# EUROPÄISCHE PATENTSCHRIFT

(11) **EP 2 448 389 B1**
(45) Veröffentlichungstag und Bekanntmachung des Hinweises auf die Patenterteilung: **14.08.2013**
(21) Anmeldenummer: 10189718.9
(22) Anmeldetag: 02.11.2010
(51) Int. Cl.: H05K 7/14, H05K 5/06, H05K 3/28

(54) **Elektrisches Gerät**
Electrical device
Appareil électrique

(43) Veröffentlichungstag der Anmeldung: 02.05.2012
(73) Patentinhaber: Siemens Aktiengesellschaft, 80333 München (DE)
(72) Erfinder: Abert, Michael, 76474, Au (DE); Ehinger, Matthias, 76149, Karlsruhe (DE); Künzler, Edmund, 76307, Karlsbad (DE)

(56) Entgegenhaltungen:
- EP-A1- 0 251 260
- WO-A1-00/11716
- WO-A1-2005/052702
- WO-A1-2010/057010
- DE-A1- 19 807 886

## Beschreibung

Die Erfindung betrifft ein elektrisches Gerät mit einem Gehäuse, welches mindestens eine mit elektronischen Bauteilen bestückte Leiterplatte, einen Hohlkörper und eine Vergussmasse aufweist.

Aus dem Siemens-Katalog "ST PCS 7", Seiten 8/31 bis 8/41, Ausgabe 2010 ist ein Automatisierungsgerät in Form eines modularen, eigensicheren I/O-Peripheriesystems bekannt, welches über einen so genannten "PROFIBUS-DP" mit einem weiteren Automatisierungsgerät in Form einer speicherprogrammierbaren Steuerung verbunden ist. Dieses I/O-Peripheriesystem weist mehrere Hardware-Komponenten auf, die über einen Rückwandbus Informationen austauschen. Eine dieser Hardware-Komponenten des I/O-Peripheriesystems ist als Stromversorgungseinheit ausgebildet, die mindestens eine mit elektronischen Bauelementen bzw. Bauteilen bestückte Leiterplatte aufweist. Diese Leiterplatte kann mit einem Füllmaterial verkapselt werden, derart, dass diese mit einer elektrisch nicht leitenden Vergussmasse vergossen wird, wodurch insbesondere die Wärmeableitung verbessert wird.

Im Folgenden wird unter Vergießen das Einfüllen einer Vergussmasse in ein Gehäuse oder in ein Gehäuseteil verstanden, in welchem eine elektronische Komponente, z. B. eine Komponente in Form einer mit elektronischen Bauteilen bestückten Leiterplatte, angeordnet ist, wobei so viel Vergussmasse eingefüllt wird, bis die Vergussmasse die Leiterplatte einschließlich ihrer elektronischen Komponenten vollständig bedeckt, was bedeutet, dass die Leiterplatte und deren Komponenten von der Vergussmasse eingekapselt sind.

Das Vergießen der mit elektronischen Bauteilen versehenen Leiterplatte bewirkt im Vergleich zu einer nicht vergossenen Leiterplatte, dass die Minimalabstände zwischen Leiterbahnen und Bauteilen deutlich kleiner ausgelegt und dass dennoch die Anforderungen im Hinblick auf die Eigensicherheit erfüllt werden können. Ferner werden dadurch Kundenanforderungen im Hinblick auf die Dimensionierung bzw. auf die Abmessungen der Stromversorgungseinheit erfüllt und darüber hinaus wirkt sich der Verguss günstig auf eine gleichmäßige Verteilung der anfallenden Verlustwärme und die Einflüsse widriger Klimabedingungen aus.

Im Rahmen eines Fertigungsprozesses wird zunächst die Leiterplatte der Stromversorgungseinheit in einen linken oder rechten Teil des Gehäuses der Stromversorgungseinheit eingebaut und in beide Gehäuseteile separat eine Vergussmasse eingefüllt. Schließlich werden beide Gehäuseteile nach einer Aushärtung der Vergussmassen zusammengesteckt, über eine Öffnung des Gehäuses wird ein von den "ausgehärteten" Vergussmassen gebildeter Hohlraum mit geeignetem Sand befüllt, um den Anforderungen im Hinblick auf die Eigensicherheit zu genügen, und anschließend die Öffnung verschlossen. Das Einfüllen einer Vergussmasse in jedes der beiden Gehäuseteile bedeutet, dass ein aufwendiges Vergießen und ein entsprechendes Aushärten der jeweiligen Vergussmasse erforderlich sind. Selbstverständlich kann jedes der beiden Gehäuseteile mit einer Leiterplatte versehen sein.

Nachteilig an der derart gefertigten, mit Sand befüllten und mit zwei vergossenen Gehäuseteilen versehenen Stromversorgungseinheit ist die räumliche Ausdehnung der unterschiedlich "ausgehärteten" Vergussmasse bei hohen Betriebs- und Umgebungstemperaturen. Der Ausdehnungskoeffizient der Vergussmasse ist gewöhnlich höher als der jeweilige Ausdehnungskoeffizient des Gehäuses, der Bauteile und der Leiterplatte. Dadurch kommt es bei höheren Temperaturen zu hohen inneren Spannungen und Drücken, die im Extremfall zu einer Zerstörung der Bauteile und/oder der Leiterbahnen und/oder des Gehäuses der Stromversorgungseinheit führen können.

Aus der DE 198 07 886 A1 ist eine Vorrichtung zur Regulierung von Druckänderungen in gegen die äußere Umgebung hermetisch abgedichteten Gehäusen bekannt, welche zur Aufnahme von elektrischen und/oder mechanischen Komponenten vorgesehen sind. Es sind geeignete Maßnahmen vorgesehen, um im Gehäuse im Hinblick auf eine Druckkompensation eine innendruckmindernde oder innendruckeliminierende Volumenänderung zu beherrschen.

WO 2005/052702 A1 offenbart einen Verteiler für die Automatisierung, welcher ein Gehäuse und eine Schaltung umfasst, wobei das Gehäuse und die Schaltung mit einem Füllmaterial vergossen sind.

Ein elektrisches Gerät gemäß dem Oberbegriff des Anspruchs 1 ist aus der DE 198 07 866 A1 bekannt.

Der Erfindung liegt die Aufgabe zugrunde, ein elektrisches Gerät der eingangs genannten Art zu schaffen, welches diese Nachteile vermeidet.

Diese Aufgabe wird durch die im kennzeichnenden Teil des Anspruchs 1 angegebenen Maßnahmen gelöst.

Vorteilhaft ist, dass der elastische Hohlkörper die räumlichen Ausdehnungen der Vergussmasse aufnehmen kann, wodurch insbesondere die Spannungen und Drücke auf das Gehäuse wesentlich vermindert werden. Darüber hinaus entfällt ein aufwendiges Vergießen der beiden Gehäuseteile; das gesamte Gehäuse wird im Rahmen eines einzigen Vergießvorgangs mit der Vergussmasse befüllt. Das Material der Leiterplatte ist bereits zulassungstechnisch erprobt, wodurch entsprechende Zertifizierungsverfahren hinsichtlich einer Zulassung des elektrischen Gerätes in explosionsgeschützten Bereichen erleichtert werden.

In einer Ausgestaltung der Erfindung ist vorgesehen, dass der Hohlkörper mit Ausnehmungen versehen ist. Dadurch wird ermöglicht, dass die Leiterplatte auch mit hohen Bauteilen bzw. Bauelementen bestückt werden kann. Diese ragen durch die Ausnehmungen, was bedeutet, dass der Hohlkörper sich nicht störend auf den Bestückungsgrad der Leiterplatte auswirkt und auch hohe Bauteile eingesetzt werden können.

Weitere vorteilhafte Ausgestaltungen der Erfindung ergeben sich aus den weiteren Unteransprüchen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: ein Gehäuse einer Stromversorgungseinheit,
- Figur 2: Komponenten einer Stromversorgungseinheit,
- Figuren 3 und 8: Draufsichten auf einen Hohlkörper,
- Figuren 4, 6 und 9: Schnittdarstellungen eines Hohlkörpers und
- Figuren 5 und 7: teilweise geschnittene Darstellungen eines Hohlkörpers und einer Leiterplatte.

Die in den Figuren dargestellten gleichen Teile sind mit gleichen Bezugszeichen versehen.

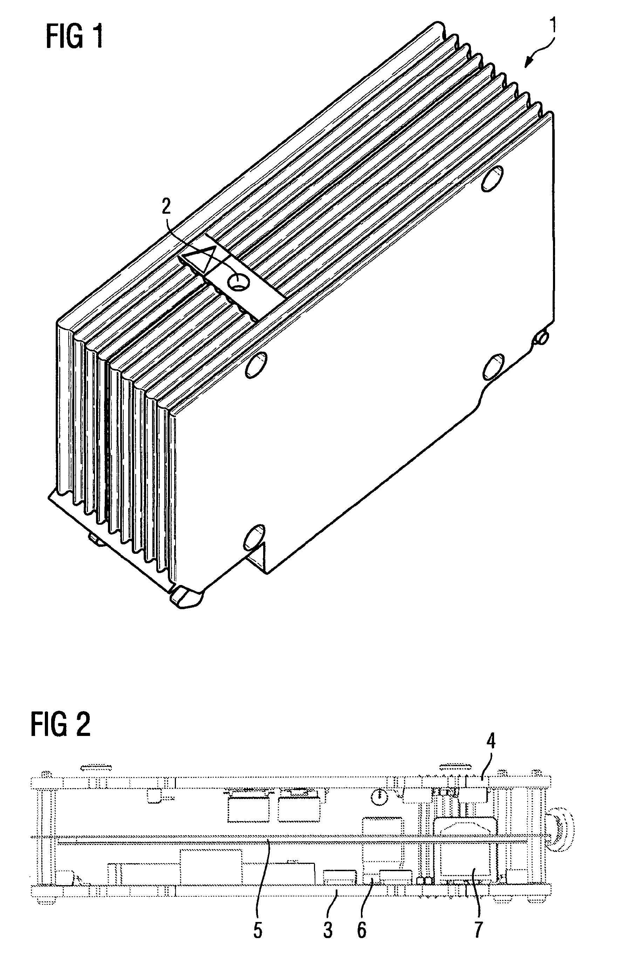

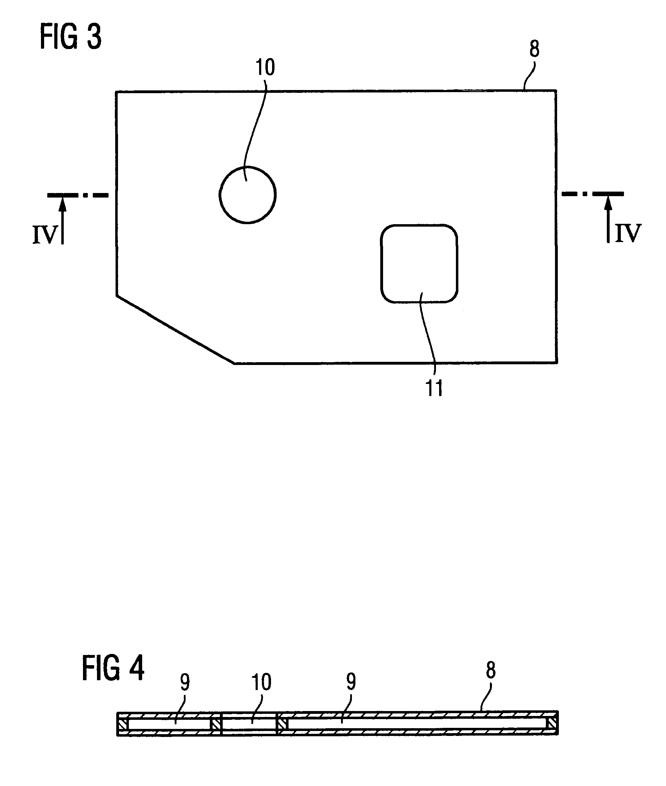

In Figur 1 ist mit 1 ein Gehäuse einer Stromversorgungseinheit bezeichnet, die für einen Einsatz in einem explosionsgeschützten Bereich geeignet ausgestaltet ist. Das Gehäuse 1 weist eine Öffnung 2 auf, die zum Einfüllen einer nicht elektrisch leitenden Vergussmasse vorgesehen ist. Diese Öffnung wird mit einer geeigneten, hier nicht dargestellten Verschlusskappe erst dann verschlossen, nachdem das Gehäuse 1 vollständig mit der Vergussmasse befüllt und die Vergussmasse ausgehärtet ist, wobei derart befüllt wird, dass luftbefüllte Hohlräume vermieden werden, um die Anforderungen im Hinblick auf die Eigensicherheit der Stromversorgungseinheit zu erfüllen. Im Innern des Gehäuses sind zwei mit Bauelementen bzw. Bauteilen bestückte Leiterplatten 3, 4 (Figur 2) parallel zu einem Hohlkörper 5 angeordnet, welcher mit Ausnehmungen versehen ist. Aufgrund der eingefüllten und ausgehärteten Vergussmasse sind die Leiterplatten 3, 4 und der Hohlkörper 5 vollständig von der Vergussmasse eingekapselt. Anstatt das Gehäuse 1 mit einer Vergussmasse zu befüllen, kann dieses mit Öl befüllt werden, welches die Leiterplatten 3, 4 und den Hohlkörper 5 umhüllt. In die Ausnehmungen ragen Bauteile 6, 7 der Leiterplatte 3, was bedeutet, dass aufgrund dieser Ausnehmungen der Hohlkörper 5 die Dimensionierung der Bauteile der Leiterplatte 3 bzgl. ihrer Höhen nicht behindert. Der Hohlkörper 5 besteht vorzugsweise aus einem elektrisch isolierenden Trägermaterial für Leiterplatten und ist entsprechend einer mehrlagigen Leiterplatte gefertigt, verklebt und verpresst, wobei ein Hohlraum hermetisch abgeschlossen ist. Figur 3 zeigt in einer Draufsicht und Figur 4 in einer Schnittdarstellung einen derartigen Hohlkörper 8 mit einem Hohlraum 9 und Ausnehmungen 10, 11, wobei selbstverständlich die verschiedenen Lagen des Hohlkörpers 8 nicht verpresst zu sein brauchen, sondern auch im Rahmen eines Reflowprozesses verlötet werden können.

Auch kann der Hohlkörper aus einer flächenhaft tief gefrästen Leiterplatte verwirklicht werden, wobei die offene Seite bzw. die offenen Seiten dieser Leiterplatte mit entsprechenden Abdeckungen geschlossen werden.

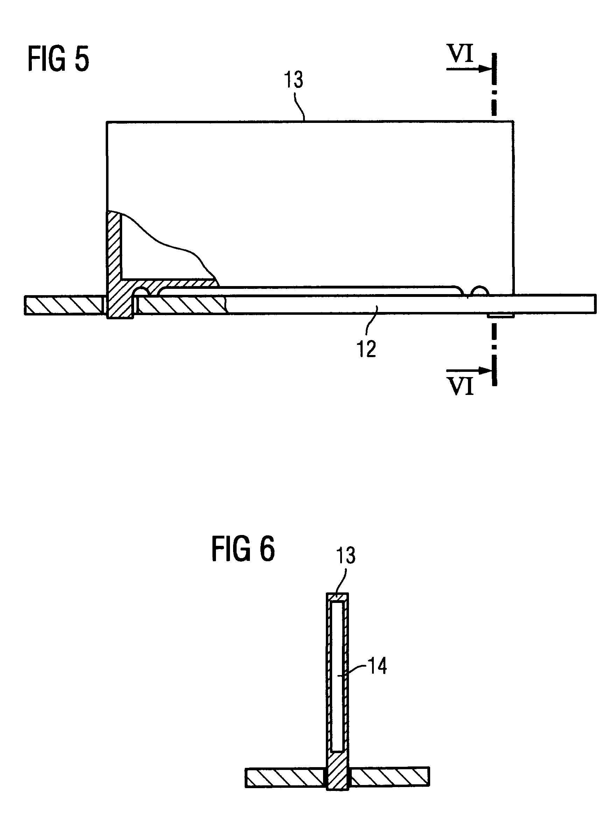

Ferner kann der Hohlkörper - wie in den Figuren 5 bis 7 dargestellt - als Bauteil verwirklicht werden, mit welchem entsprechend einem elektronischen Bauteil eine Leiterplatte automatisch bestückt und verlötet wird. Eine mit hier nicht dargestellten Bauelementen bestückte Leiterplatte 12 ist ferner mit einem im Wesentlichen quaderförmigen Hohlkörper in Form einer unbestückten ,,Hohlraum-Leiterplatte" 13 bestückt, die einen Hohlraum 14 aufweist. Der Hohlkörper kann auch als Hohlbecher 15 ausgebildet sein, mit welchem eine Leiterplatte 16 bestückt ist.

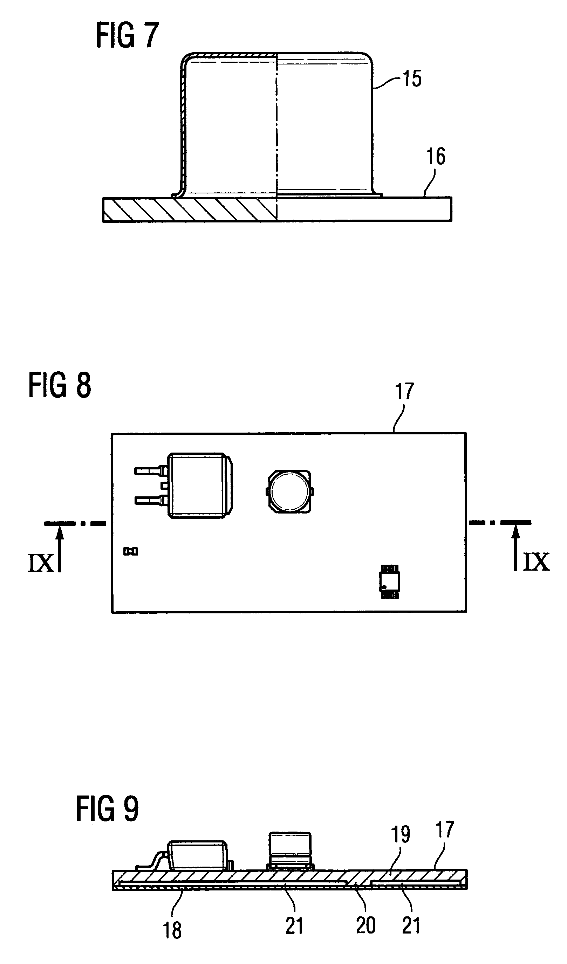

In einer weiteren Ausführungsform ist der Hohlkörper als eine mit elektronischen Bauteilen bestückte Leiterplatte 17 ausgebildet (Figuren 8 und 9). Diese Leiterplatte 17 weist eine untere Leiterplattenlage 18 auf, welche zusammen mit einer oberen Leiterplattenlage 19 und einem Kontaktierungsbereich 20 Hohlräume 21 bildet.

## Patentansprüche

1. Elektrisches Gerät mit einem Gehäuse (1), welches mindestens eine mit elektronischen Bauteilen bestückte Leiterplatte (3, 4), einen Hohlkörper (5, 8, 13, 15) und eine Vergussmasse aufweist, **dadurch gekennzeichnet, dass**
das Gehäuse vollständig mit der Vergussmasse befüllt ist und der Hohlkörper (5, 8, 13, 15) zum Aufnehmen der räumlichen Ausdehnung der Vergussmasse bei hohen Betriebs- und Umgebungstemperaturen eine mit elektronischen Bauteilen bestückte Leiterplatte (17) ist, wobei die Leiterplatten (3, 4, 17) von der Vergussmasse umhüllt sind.

2. Elektrisches Gerät nach Anspruch 1, **dadurch gekennzeichnet, dass** der Hohlkörper (5, 8, 13, 15) mit Ausnehmungen (10, 11) versehen ist.

3. Elektrisches Gerät nach Anspruch 1 oder 2, **dadurch gekennzeichnet, dass** das elektrische Gerät ein Automatisierungsgerät oder eine Hardware-Komponente dieses Automatisierungsgeräts ist.

## Claims

1. Electrical appliance having a housing (1) which has at least one printed circuit board (3, 4) populated with electronic components, a hollow body (5, 8, 13, 15) and an encapsulation compound, **characterized in that**
the housing is completely filled with the encapsulation compound and the hollow body (5, 8, 13, 15), for accommodating the spatial expansion of the encapsulation compound at high operating and ambient temperatures, is a printed circuit board (17) populated with electronic components, wherein the printed circuit boards (3, 4, 17) are sheathed by the encapsulation compound.

2. Electrical appliance according to Claim 1, **characterized in that** the hollow body (5, 8, 13, 15) is provided with recesses (10, 11).

3. Electrical appliance according to Claim 1 or 2, **characterized in that** the electrical appliance is an automation appliance or a hardware component of this automation appliance.

## Revendications

1. Appareil électrique ayant un boîtier ( 1 ), qui a au moins une plaquette ( 3, 4 ) à circuit imprimé équipée de composants électroniques, un corps ( 5, 8, 13, 15 ) creux et une masse de scellement, **caractérisé en ce que**
le boîtier est rempli complètement de la masse de scellement et le corps ( 5, 8, 13, 15 ) creux est, pour l'absorption de la dilatation dans l'espace de la masse de scellement à des températures de fonctionnement et ambiantes hautes, une plaquette (17) à circuit imprimé équipée de composants électroniques, les plaquettes ( 3, 4, 17 ) à circuit imprimé étant enrobées de la masse de scellement.

2. Appareil électrique suivant la revendication 1, **caractérisé en ce que** le corps ( 5, 8, 13, 15 ) creux est pourvu d'évidements ( 10, 11 ).

3. Appareil électrique suivant la revendication 1 ou 2, **caractérisé en ce que** l'appareil électrique est un appareil d'automatisation ou un composant matériel de cet appareil d'automatisation.
